# EUROPEAN PATENT SPECIFICATION

(11) **EP 3 866 191 B1**
(45) Date of publication and mention of the grant of the patent: **24.04.2024**
(21) Application number: 19871752.2
(22) Date of filing: 30.08.2019
(51) Int. Cl.: H01L 23/36, B32B 7/027, B32B 7/06, H05K 7/20

(54) **ELECTRICALLY-INSULATIVE HEAT-DISSIPATING SHEET EQUIPPED WITH RELEASE SHEET**
ELEKTRISCH ISOLIERENDE, WÄRMEABLEITENDE SCHICHT MIT TRENNSCHICHT
FEUILLE DE DISSIPATION DE CHALEUR ÉLECTRIQUEMENT ISOLANTE ÉQUIPÉE D'UNE FEUILLE DE LIBÉRATION

(30) Priority: 09.10.2018 JP 2018191005
(43) Date of publication of application: 18.08.2021
(73) Proprietor: Nitto Shinko Corporation, Sakai-shi, Fukui 910-0381 (JP)
(72) Inventor: KITAGAWA, Yoshihide, Sakai-shi, Fukui 910-0381 (JP); TOMOYASU, Yudai, Sakai-shi, Fukui 910-0381 (JP); MAKIDA, Hiroyuki, Sakai-shi, Fukui 910-0381 (JP)
(74) Representative: Stolmár & Partner Patentanwälte PartG mbB
(86) International application number: PCT/JP2019/034186
(87) International publication number: WO 2020/075413

(56) References cited:
- JP-A- H11 181 368
- JP-A- 2002 294 192
- JP-A- 2015 103 581
- JP-A- 2015 176 953
- JP-A- 2018 022 767
- JP-B1- 6 327 630

## Description

### FIELD

The present invention relates to a release sheet-equipped insulating heat dissipation sheet.

### BACKGROUND

Conventionally, there has been widely used an insulating heat dissipation sheet having enhanced thermal conductivity by a thermosetting resin having an inorganic filler dispersed therein, as compared with the thermal conductivity of the thermosetting resin itself.

The insulating heat dissipation sheet is used for, for example, producing a semiconductor module by being interposed between a module body obtained by resin molding a semiconductor element and a metal-made heat dissipation member that is externally exposed in order to dissipate the heat generated by the semiconductor element. Further, when the semiconductor module is produced, a release sheet-equipped insulating heat dissipation sheet is used. The release sheet-equipped insulating heat dissipation sheet is used, for example, in the manner as described below. First, the release sheet-equipped insulating heat dissipation sheet is layered on the heat dissipation member on the insulating heat dissipation sheet side, and the release sheet is peeled off. Then, the insulating heat dissipation sheet is layered on the module body through the surface of the insulating heat dissipation sheet exposed by peeling off the release sheet. Next, the insulating heat dissipation sheet is thermally cured to allow the module body, the insulating heat dissipation sheet, and the heat dissipation member to be integrated together to thereby produce the semiconductor module.

Further, the release sheet-equipped insulating heat dissipation sheet is not limited to an application for producing the semiconductor module, and can be used for an application in which the insulating heat dissipation sheet is interposed between one adherend and another adherend.

### CITATION LIST

### Patent Literature

Patent Literature 1: JP 2015-176953 A

### SUMMARY

### Technical Problem

In recent years, demands have arisen for insulating heat dissipation sheets having even more excellent heat dissipation properties, and accordingly demands have arisen for increasing a content ratio of an inorganic filler in the insulating heat dissipation sheets. However, the adhesion between the insulating heat dissipation sheet and the adherend is lowered as the content ratio of the inorganic filler in the insulating heat dissipation sheet is increased. Therefore, it may be required to increase the adhesion between the insulating heat dissipation sheet and the adherend. However, an investigation has not been yet made on the release sheet-equipped insulating heat dissipation sheet having excellent adhesiveness between the insulating heat dissipation sheet and the adherend.

Therefore, it is an object of the present invention to provide a release sheet-equipped insulating heat dissipation sheet having excellent adhesiveness between the insulating heat dissipation sheet and the adherend.

### Solution to Problem

A release sheet-equipped insulating heat dissipation sheet according to the present invention including: an insulating heat dissipation sheet including an inorganic filler and a thermosetting resin; and a release sheet layered on the insulating heat dissipation sheet, the insulating heat dissipation sheet including one adhesive surface configured to be adhered to a first adherend and another adhesive surface configured to be adhered to a second adherend, the release sheet including a transfer sheet having a front surface in contact with the one adhesive surface, a positioning sheet adhered to a back surface of the transfer sheet, and an adhesive used for adhesion between the transfer sheet and the positioning sheet, the insulating heat dissipation sheet and the transfer sheet respectively having outer edges matching in shape with each other, the transfer sheet having a surface roughness transferred to the insulating heat dissipation sheet, the positioning sheet having an area larger than either of the insulating heat dissipation sheet and the transfer sheet, and being configured for use in positioning the insulating heat dissipation sheet relative to the second adherend when the insulating heat dissipation sheet is adhered to the second adherend.

In one embodiment of the release sheet-equipped insulating heat dissipation sheet according to the present invention, the adhesive is a pressure-sensitive adhesive.

### BRIEF DESCRIPTION OF DRAWINGS

Fig. 1 is a schematic sectional view showing a cross-sectional structure of a release sheet-equipped insulating heat dissipation sheet of an embodiment.
Fig. 2 is a schematic sectional view showing a cross-sectional structure of a laminated sheet of an embodiment.

### DESCRIPTION OF EMBODIMENTS

Hereinafter, an embodiment of the present invention will be described with reference to the attached drawings.

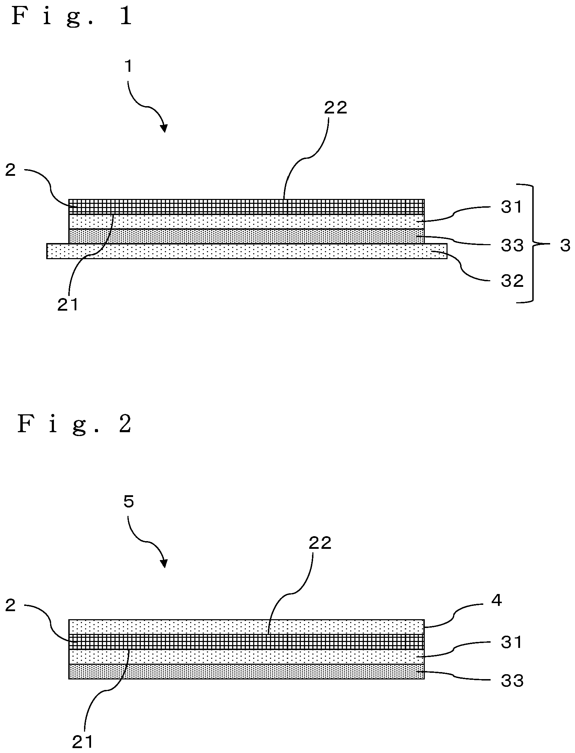

As shown in Fig. 1, a release sheet-equipped insulating heat dissipation sheet 1 according to this embodiment includes an insulating heat dissipation sheet 2 including an inorganic filler and a thermosetting resin, and a release sheet 3 layered on the insulating heat dissipation sheet 2. The insulating heat dissipation sheet 2 has one adhesive surface 21 configured to be adhered to a first adherend and another adhesive surface 22 configured to be adhered to a second adherend. The one adhesive surface 21 is a surface on the opposite side to the other adhesive surface 22. The release sheet 3 includes a transfer sheet 31 having a surface in contact with the one adhesive surface 21, and a positioning sheet 32 adhered to the transfer sheet 31 from the back surface side of the transfer sheet 31. The release sheet 3 further includes an adhesive for use in adhering the transfer sheet 31 and the positioning sheet 32 to each other. Specifically, the release sheet 3 includes a double-sided adhesive sheet 33 including a base sheet, both surfaces of the base sheet being coated with the adhesive. The insulating heat dissipation sheet 2 and the transfer sheet 31 respectively have outer edges matching in shape with each other. A surface roughness of the transfer sheet 31 is transferred to the insulating heat dissipation sheet 2. The positioning sheet 32 has an area larger than the insulating heat dissipation sheet 2 and the transfer sheet 31, and is used for positioning the insulating heat dissipation sheet 2 relative to the second adherend when the insulating heat dissipation sheet 2 is adhered to the second adherend.

The release sheet-equipped insulating heat dissipation sheet 1 according to this embodiment is used for producing a semiconductor module in which the insulating heat dissipation sheet is interposed between a module body obtained by resin molding a semiconductor element and a metal-made heat dissipation member that is externally exposed in order to dissipate the heat generated by the semiconductor element.

The insulating heat dissipation sheet 2 is formed of a resin composition including a thermosetting resin and an inorganic filler. The thermosetting resin serving as a base resin of the resin composition is not particularly limited, but examples thereof include an epoxy resin and a phenol resin.

As the epoxy resin, for example, various kinds of epoxy resins such as bisphenol A epoxy resins, modified bisphenol A epoxy resins, bisphenol F epoxy resins, modified bisphenol F epoxy resins, triphenylmethane epoxy resins, cresol novolac epoxy resins, biphenyl epoxy resins, dicyclopentadiene epoxy resins, phenol novolac epoxy resins, or phenoxy resins can be employed individually or two or more of them can be employed in combination.

Examples of the phenol resin that can be used herein include a dicyclopentadiene phenol resin, a novolac phenol resin, a cresol novolac resin, a phenol aralkyl resin, and a triphenylmethane phenol resin. Among them, a triphenylmethane phenol resin is advantageous in heat resistance, and a phenol aralkyl resin is preferably used in terms of exhibiting good adhesiveness to the metal-made heat dissipation member.

In the case where an epoxy resin is employed as the thermosetting resin, thermosetting properties may be adjusted by further adding a curing agent or a curing accelerator for the epoxy resin to the thermosetting resin. Examples of the curing agent that can be used herein include amine-based curing agents such as diaminodiphenylsulfone, dicyandiamide, diaminodiphenylmethane, or triethylenetetramine, and acid anhydride-based curing agents. Further, the novolac type phenol resin or the like can be included in the thermosetting resin as a curing agent for curing the epoxy resin. Examples of the curing accelerator include amine-based curing accelerators such as imidazoles, triphenylphosphate (TPP), or boron trifluoride monoethylamine.

On the other hand, in the case where a phenol resin is employed as the thermosetting resin, hexamethylenetetramine, various kinds of bi- or higher functional epoxy compounds, isocyanates, trioxane, cyclic formal, or the like may be included as a curing agent for curing the phenol resin.

The inorganic filler is not specifically limited, as long as it has a higher thermal conductivity than the thermosetting resin, but examples thereof include particles of boron nitride, aluminum nitride, silicon nitride, gallium nitride, aluminum oxide, silicon carbide, silicon dioxide, magnesium oxide, and diamond.

The thickness of the insulating heat dissipation sheet 2 is preferably 80 to 300 pm, more preferably 100 to 200 pm.

The type and the amount of the inorganic filler in the insulating heat dissipation sheet 2 are adjusted so that the thermal conductivity of the insulating heat dissipation sheet 2 is preferably 2 W/m·K or more, more preferably 4W/m·K or more when the thermosetting resin is sufficiently cured (that is, cured to the C stage). Further, the type and the amount of the inorganic filler in the insulating heat dissipation sheet 2 are adjusted so that the thermal conductivity of the insulating heat dissipation sheet 2 is preferably 16 W/m·K or less, more preferably 14 W/m·K or less when the thermosetting resin is sufficiently cured (that is, cured to the C stage). The thermal conductivity can usually be measured by a xenon flash analyzer (e.g., "Type LFA-447 " manufactured by NETZSCH). Without limitation to the xenon flash analyzer, the thermal conductivity can be measured by other methods such as a laser flash method or a TWA method. In the laser flash method, the measurement can be made by using, for example, a "TC-9000" manufactured by ULVAC-RIKO Inc. In the TWA method, the measurement can be made by using "ai-Phase mobile" manufactured by Eye Phase Co., Ltd.

In terms of exhibiting excellent electric insulating properties, a volume resistivity of the insulating heat dissipation sheet 2 is preferably 1×10¹³ Ω·cm or more, more preferably 1×10¹⁴ Ω·cm or more, when the thermosetting resin is sufficiently cured (that is, cure to the C stage). The volume resistivity can be measured according to JIS C2139-3-1:2018.

The transfer sheet 31 of the release sheet 3 may be formed of, for example, a polymer film, a metal foil, or a fiber sheet.

Examples of the polymer film include a resin film formed of: a polyester resin such as polyethylene terephthalate, polybutylene terephthalate, polyethylene naphthalate, polybutylene naphthalate, polylactic acid, or polyarylate; a polyolefin resin such as polyethylene or polypropylene; an aliphatic polyamide resin such as polyamide 6, polyamide 6,6, polyamide 11, or polyamide 12; an aromatic polyamide resin such as poly-p-phenyleneterephthalamide or poly-m-phenyleneisophthalamide; a chlorine-based resin such as polyvinyl chloride or polyvinylidene chloride; a fluorine-based resin such as polytetrafluoroethylene, tetrafluoroethylene-perfluoroalkylvinyl ether copolymer, tetrafluoroethylene-hexafluoropropylene copolymer, tetrafluoroethylene-ethylene copolymer, or polyvinylidene fluoride; a polyimide resin; a polycarbonate resin; an acrylic resin; a polyphenylene sulfide resin; a polyurethane resin; or a polyvinyl alcohol resin.

Examples of the metal foil include a metal foil made of copper, aluminum, nickel, iron, or an alloy thereof. The metal foil may be a clad foil formed by bonding different metals to each other or a plated foil formed by plating a different metal.

Examples of the fiber sheet include a polyester fiber nonwoven fabric, a pulp sheet, a glass mat, and a carbon fiber sheet.

The thickness of the transfer sheet 31 is preferably 25 to 250 pm, more preferably 50 to 188 pm.

The transfer sheet 31 is preferably an antistatic polyethylene terephthalate sheet.

The positioning sheet 32 may be formed of, for example, a polymer film, a metal foil, or a fiber sheet.

Examples of the polymer film include a resin film formed of: a polyester resin such as polyethylene terephthalate, polybutylene terephthalate, polyethylene naphthalate, polybutylene naphthalate, polylactic acid, or polyarylate; a polyolefin resin such as polyethylene or polypropylene; an aliphatic polyamide resin such as polyamide 6, polyamide 6,6, polyamide 11, or polyamide 12; an aromatic polyamide resin such as poly-p-phenyleneterephthalamide or poly-m-phenyleneisophthalamide; a chlorine-based resin such as polyvinyl chloride or polyvinylidene chloride; a fluorine-based resin such as polytetrafluoroethylene, tetrafluoroethylene-perfluoroalkylvinyl ether copolymer, tetrafluoroethylene-hexafluoropropylene copolymer, tetrafluoroethylene-ethylene copolymer, or polyvinylidene fluoride; a polyimide resin; a polycarbonate resin; an acrylic resin; a polyphenylene sulfide resin; a polyurethane resin; or a polyvinyl alcohol resin.

Examples of the metal foil include a metal foil made of copper, aluminum, nickel, iron, or an alloy thereof. The metal foil may be a clad foil formed by bonding different metals to each other or a plated foil formed by plating a different metal.

Examples of the fiber sheet include a polyester fiber nonwoven fabric, a pulp sheet, a glass mat, and a carbon fiber sheet.

The positioning sheet 32 is preferably an antistatic polyethylene terephthalate sheet.

The double-sided adhesive sheet 33 has a layer of a base sheet (a base sheet layer), an adhesive layer (a first adhesive layer) that is in contact with one surface of the base sheet layer, and an adhesive layer (a second adhesive layer) that is in contact with the other surface of the base sheet layer. Examples of the adhesive include a pressure-sensitive adhesive. Examples of the pressure-sensitive adhesive include an acrylic-based adhesive, a rubber-based adhesive, and a silicone-based adhesive.

Examples of the material for forming the base sheet include a polymer film and a fiber sheet. Examples of the polymer film include a resin film formed of: a polyester resin such as polyethylene terephthalate, polybutylene terephthalate, polyethylene naphthalate, polybutylene naphthalate, polylactic acid, or polyarylate; a polyolefin resin such as polyethylene or polypropylene; an aliphatic polyamide resin such as polyamide 6, polyamide 6,6, polyamide 11, or polyamide 12; an aromatic polyamide resin such as poly-p-phenyleneterephthalamide or polym-phenyleneisophthalamide; a chlorine-based resin such as polyvinyl chloride or polyvinylidene chloride; a fluorine-based resin such as polytetrafluoroethylene, tetrafluoroethylene-perfluoroalkylvinyl ether copolymer, tetrafluoroethylene-hexafluoropropylene copolymer, tetrafluoroethylene-ethylene copolymer, or polyvinylidene fluoride; a polyimide resin; a polycarbonate resin; an acrylic resin; a polyphenylene sulfide resin; a polyurethane resin; or a polyvinyl alcohol resin. Examples of the fiber sheet include a polyester fiber nonwoven fabric, a pulp sheet, a glass mat, and a carbon fiber sheet.

The thickness of the double-sided adhesive sheet 33 is preferably 5 to 300 pm, more preferably 30 to 70 pm. Further, the thickness of each of the adhesive layers is preferably 2 to 100 pm, more preferably 10 to 30 pm. The release sheet-equipped insulating heat dissipation sheet according to this embodiment is excellent in adhesiveness between the transfer sheet 31 and the positioning sheet 32 because of the adhesive layers each having a thickness of 2 pm or more. Further, because the adhesive layers each have a thickness of 100 pm or less, the release sheet-equipped insulating heat dissipation sheet according to this embodiment can suppress the adhesive from flowing out when the insulating heat dissipation sheet is adhered to the adherend by heating. Moreover, the total thicknesses of the adhesive layers (i.e., the total of the thickness of the first adhesive layer and the thickness of the second adhesive layer) is preferably in a range of 4 to 200 pm, more preferably in a range of 20 to 60 pm. The release sheet-equipped insulating heat dissipation sheet according to this embodiment is excellent in adhesiveness between the transfer sheet 31 and the positioning sheet 32 because the total thickness of the adhesive layers of the double-sided adhesive sheet 33 is 4 pm or more. Further, because the total thickness of the adhesive layer of the double-sided adhesive sheet 33 is 200 pm or less, the release sheet-equipped insulating heat dissipation sheet according to this embodiment can suppress the adhesive from flowing out when the insulating heat dissipation sheet is adhered to the adherend by heating.

Next, a method for producing the release sheet-equipped insulating heat dissipation sheet according to this embodiment will be described.

In the method for producing the release sheet-equipped insulating heat dissipation sheet according to this embodiment, a transfer sheet for transferring the surface roughness to the insulating heat dissipation sheet and a coating liquid including a thermosetting resin, an inorganic filler, and an organic solvent are first prepared. Next, one surface of the transfer sheet for transferring the surface roughness to the insulating heat dissipation sheet is coated with the coating liquid, thereby forming a coat on the transfer sheet. Then, the coat is dried to obtain the transfer sheet having a dry coat formed on the one surface. Next, two transfer sheets each having a dry coat formed on one surface are prepared, and these transfer sheets are layered over each other with the dry coats facing each other, followed by hot pressing so that the two dry coats are layered on each other and integrated together to obtain an insulating heat dissipation sheet having the transfer sheets on both surfaces. Then, a double-sided adhesive sheet having a base sheet both surfaces of which are coated with an adhesive is prepared. Next, the double-sided adhesive sheet is layered on one of the transfer sheets respectively provided on both surfaces of the insulating heat dissipation sheet to obtain a laminated sheet 5 in which, a first transfer sheet 4, an insulating heat dissipation sheet 2, a second transfer sheet 31, and the double-sided adhesive sheet 33 are layered in this order (Fig.2). Then, the laminated sheet 5 is cut out to have its surface having a certain shape. Next, a positioning sheet 32, which has an area larger than the cut-out laminated sheet 5 and is configured for use in positioning the insulating heat dissipation sheet 2 relative to the second adherend when the insulating heat dissipation sheet 2 is adhered to the second adherend, is prepared. Then, the cut-out laminated sheet 5 and the positioning sheet 32 are layered over each other and pressed together on the double-sided adhesive sheet 33 side to obtain a positioning sheet-equipped laminated sheet. Next, the first transfer sheet 4 is peeled off from the positioning sheet-equipped laminated sheet to obtain the release sheet-equipped insulating heat dissipation sheet 1 according to this embodiment.

The release sheet-equipped insulating heat dissipation sheet according to this embodiment configured as described above thus has the following advantages.

That is, the release sheet-equipped insulating heat dissipation sheet 1 according to this embodiment includes the insulating heat dissipation sheet 2 including an inorganic filler and a thermosetting resin, and the release sheet 3 layered on the insulating heat dissipation sheet 2. The insulating heat dissipation sheet 2 includes one adhesive surface 21 configured to be adhered to the first adherend and the other adhesive surface 22 configured to be adhered to the second adherend. The release sheet includes the transfer sheet 31 having a front surface in contact with the one adhesive surface, the positioning sheet 32 adhered to a back surface of the transfer sheet 31, and the adhesive for use in adhering the transfer sheet 31 and the positioning sheet 32 to each other. The insulating heat dissipation sheet 2 and the transfer sheet 31 respectively have outer edges matching in shape with each other. The surface roughness of the transfer sheet 31 is transferred to the insulating heat dissipation sheet 2. The positioning sheet 32 has an area larger than the insulating heat dissipation sheet 2 and the transfer sheet 31, and is configured for use in positioning the insulating heat dissipation sheet 2 relative to the second adherend when the insulating heat dissipation sheet 2 is adhered to the second adherend. According to the release sheet-equipped insulating heat dissipation sheet 1, the surface roughness of the transfer sheet 31 is transferred to the insulating heat dissipation sheet 2. Thus, the insulating heat dissipation sheet 2 can have a surface roughness being excellent in adhesiveness to the first adherend. Accordingly, the release sheet-equipped insulating heat dissipation sheet 1 is excellent in adhesiveness between the insulating heat dissipation sheet and the first adherend.

According to this embodiment, it is possible to provide a release sheet-equipped insulating heat dissipation sheet excellent in adhesiveness between the insulating heat dissipating sheet and the adherend.

Further, according to the insulating heat dissipating sheet with release sheet 1, the transfer sheet 31 and the positioning sheet 32 can be adhered to each other by selecting an adhesive capable of providing adhesiveness even with eliminating the heating to the insulating heat dissipating sheet 2 or suppressing the heating thereto. As a result, curing of the thermosetting resin of the insulating heat dissipating sheet can be suppressed so that the insulating heat dissipation sheet is more excellent in adhesiveness to the first adherend and the second adherend. Moreover, there is an advantage that the insulating heat dissipation sheet having a desired thickness can be easily formed since the curing of the thermosetting resin of the insulating heat dissipation sheet can be suppressed.

In the release sheet-equipped insulating heat dissipation sheet 1 according to this embodiment, the adhesive is a pressure-sensitive adhesive. The release sheet-equipped insulating heat dissipation sheet 1 has an advantage of being easy to produce since the adhesive is a pressure-sensitive adhesive.

The release sheet-equipped insulating heat dissipation sheet according to the present invention is not limited to the aforementioned embodiment. Further, the release sheet-equipped insulating heat dissipation sheet according to the present invention is not limited also to that having the aforementioned operational effects.

For example, the release sheet-equipped insulating heat dissipation sheet according to this embodiment includes a double-sided adhesive sheet, but the release sheet-equipped insulating heat dissipation sheet according to the present invention may not include a double-sided adhesive sheet. In such a case, the thickness of the adhesive layer is preferably from 5 to 300 pm, more preferably from 30 to 70 pm. The adhesive is preferably, for example, a pressure-sensitive adhesive, a cold curing adhesive, or a UV curing adhesive, in terms of eliminating or suppressing the heating to the insulating heat dissipation sheet 2. Examples of the cold curing adhesive include a cyanoacrylate-based cold curing adhesive. Examples of the UV curing adhesive include a commercially available UV curing adhesive.

### REFERENCE SIGNS LIST

1: Release sheet-equipped insulating heat dissipation sheet
2: Insulating heat dissipation sheet
3: Release sheet
4: First transfer sheet
5: Laminated sheet
21: One adhesive surface
22: Other adhesive surface
31: Transfer sheet (second transfer sheet)
32: Positioning sheet
33: Double-sided adhesive sheet

## Claims

1. A release sheet-equipped insulating heat dissipation sheet comprising:
an insulating heat dissipation sheet comprising an inorganic filler and a thermosetting resin; and
a release sheet layered on the insulating heat dissipation sheet,
the insulating heat dissipation sheet comprising one adhesive surface configured to be adhered to a first adherend and another adhesive surface configured to be adhered to a second adherend,
the release sheet comprising a transfer sheet having a front surface in contact with the one adhesive surface, a positioning sheet adhered to a back surface of the transfer sheet, and an adhesive used for adhesion between the transfer sheet and the positioning sheet,
the insulating heat dissipation sheet and the transfer sheet respectively having outer edges matching in shape with each other,
the transfer sheet having a surface roughness transferred to the insulating heat dissipation sheet,
the positioning sheet having an area larger than either of the insulating heat dissipation sheet and the transfer sheet, and being configured for use in positioning the insulating heat dissipation sheet relative to the second adherend when the insulating heat dissipation sheet is adhered to the second adherend.

2. The release sheet-equipped insulating heat dissipation sheet according to claim 1, wherein
the adhesive is a pressure-sensitive adhesive.

## Patentansprüche

1. Isolierende Wärmeableitungsfolie, die mit einer Trennfolie ausgestattet ist und die Folgendes umfasst:
eine isolierende Wärmeableitungsfolie, die einen anorganischen Füllstoff und ein wärmehärtendes Harz umfasst; und
eine Trennfolie, die auf die isolierende Wärmeableitungsfolie geschichtet ist, wobei
die isolierende Wärmeableitungsfolie eine Klebefläche umfasst, die so eingerichtet ist, dass sie an eine erste Haftfläche geklebt werden kann, und eine andere Klebefläche, die so eingerichtet ist, dass sie an eine zweite Haftfläche geklebt werden kann,
die Trennfolie eine Übertragungsfolie umfasst, die eine Vorderfläche aufweist, die mit der einen Klebefläche in Kontakt ist, eine Positionierungsfolie, die an einer Rückfläche der Übertragungsfolie haftet, und ein Klebemittel, das für die Haftung zwischen der Übertragungsfolie und der Positionierungsfolie verwendet wird,
die isolierende Wärmeableitungsfolie und die Übertragungsfolie jeweils äußere Kanten, die in ihrer Form zueinander passen, aufweisen,
die Übertragungsfolie eine Oberflächenrauhigkeit aufweist, die auf die isolierende Wärmeableitungsfolie übertragen wird,
die Positionierungsfolie eine Fläche aufweist, die größer ist als die isolierende Wärmeableitungsfolie und die Übertragungsfolie, und die zur Verwendung bei der Positionierung der isolierenden Wärmeableitungsfolie relativ zu der zweiten Haftfläche eingerichtet ist, wenn die isolierende Wärmeableitungsfolie an die zweite Haftfläche geklebt wird.

2. Isolierende Wärmeableitungsfolie, die mit einer Trennfolie ausgestattet ist, nach Anspruch 1, wobei
Klebemittel ein druckempfindliches Klebemittel ist.

## Revendications

1. Feuille isolante de dissipation de chaleur équipée d'une feuille de libération, comprenant :
une feuille isolante de dissipation de chaleur comprenant une charge inorganique et une résine thermodurcissable ; et
une feuille de libération superposée à la feuille isolante de dissipation de chaleur,
la feuille isolante de dissipation de chaleur comprenant une surface adhésive configurée pour être collée à un premier élément adhérent et une autre surface adhésive configurée pour être collée à un second élément adhérent,
la feuille de libération comprenant une feuille de transfert dont la surface avant est en contact avec la surface adhésive unique, une feuille de positionnement collée à la surface arrière de la feuille de transfert,
et un adhésif utilisé pour l'adhésion entre la feuille de transfert et la feuille de positionnement,
la feuille isolante de dissipation de chaleur et la feuille de transfert ayant respectivement des bords extérieurs dont la forme correspond à celle de l'autre,
la feuille de transfert ayant une rugosité de surface transférée à la feuille isolante de dissipation de chaleur,
la feuille de positionnement ayant une surface plus grande que la feuille isolante de dissipation de chaleur et la feuille de transfert, et étant configurée pour être utilisée dans le positionnement de la feuille isolante de dissipation de chaleur par rapport au second élément adhérent lorsque la feuille de dissipation isolante de chaleur est collée au second élément adhérent.

2. Feuille isolante de dissipation de chaleur équipée d'une feuille de libération selon la revendication 1, dans laquelle
l'adhésif est un adhésif sensible à la pression.
